# EUROPEAN PATENT APPLICATION

(11) **EP 2 701 476 A1**
(43) Date of publication of application: **26.02.2014**
(21) Application number: 12181136.8
(22) Date of filing: 21.08.2012
(51) Int. Cl.: H05K 7/14, H05K 9/00

(54) **Electronic module and modular electronic system using the same**

(71) Applicant: ABB Technology AG, 8050 Zürich (CH)
(72) Inventor: Kuhn, Erich, 5436 Würenlos (CH); Grünig, Frank, 5234 Villingen (CH); Cottet, Didier, 8050 Zürich (CH); Agostini, Francesco, 4800 Zofingen (CH); Cimino, Mikael, 40140 Soustons (FR); Velthuis, Rudi, 79787 Lauchringen (DE); Gradinger, Thomas, 5032 Rohr (CH)
(74) Representative: ABB Patent Attorneys

(57) **Abstract**

A modular electronic system for medium and high voltages is provided. The system includes a cabinet (160) having a number of slots (120) arranged in an array, at least one electronic module (130) provided in a slot (120) of the cabinet, the module including an enclosure (10) with a three dimensional shape, having an enclosure wall (30) comprising a dielectric material, and a field shaping conductive layer (60) abutting a face (70) of the enclosure wall (30), and an electronic device (20) located in the enclosure (10), wherein the field shaping conductive layer (60) is electrically connectable to a predefined electric potential in an operating state of the modular electronic system (100).

## Description

### TECHNICAL FIELD

The present disclosure relates to electronic modules and systems, and particularly to the insulation of electronic modules. In particular, the invention relates to a modular electric and/or electronic system with modules having components located in at least one enclosure.

### BACKGROUND OF THE INVENTION

Power electronics building blocks (PEBB) are used in wide field of applications, for example in voltage conversion. Thereby, particularly in the medium to high voltage range, it is a demanding task to integrate the involved semiconductor based circuitry in an economic space, and to simultaneously fulfill the requirements with respect to heat dissipation, i.e. cooling, and safety against the problem of partial discharges.

Some attempts have been made to insulate such PEBBs by solid materials, e.g. by using dielectric housings. Examples for such concepts can be found in Berth M.: "New Main Circuits, HV-Design of Submodules", ABB-Report, HIP49/ATP5-3, and in Steiner M., Reinold, H.: "Medium Frequency Topology in Railway Applications", European Railway Review (EPE), 2007, Aalborg, Denmark. However, none of these approaches has as of yet led to an application in marketable PEBB products, partly due to persisting problems with partial discharges.

In view of the above, there is a need for power electronics modules and systems which avoid the disadvantages of the known solutions.

### SUMMARY OF THE INVENTION

The problems mentioned above are at least partly solved by a modular electronic system according to claim 1.

In a first aspect, a modular electronic system for medium and high voltages is provided. The system includes a cabinet having a number of slots arranged in an array, at least one electronic module provided in a slot of the cabinet, the module including an enclosure with a three dimensional shape, having an enclosure wall comprising a solid dielectric material, and a field shaping conductive layer abutting a face of the enclosure wall, and an electronic device located in the enclosure, wherein the field shaping conductive layer is electrically connectable to a predefined electric potential in an operating state of the modular electronic system.

Further aspects, advantages and features of the present invention are apparent from the dependent claims, the description and the accompanying drawings.

### BRIEF DESCRIPTION OF THE DRAWINGS

A full and enabling disclosure, including the best mode thereof, to one of ordinary skill in the art is set forth more particularly in the remainder of the specification, including reference to the accompanying figures wherein:

Fig. 1 schematically shows a partial cross-sectional view of an enclosure for a system according to embodiments;

Fig. 2 schematically shows a perspective front view of an electronic module for a system according to embodiments;

Fig. 3 schematically shows a cross sectional view of an enclosure of an electronic module for a system according to embodiments;

Fig. 4 shows a perspective front view of a frame-like insulation body for an enclosure according to embodiments;

Fig. 5 schematically shows a front view of a system according to embodiments;

Fig. 6 schematically shows a perspective front view of a system according to embodiments;

Fig. 7 shows a cross sectional side view of a system according to embodiments.

Fig. 8 schematically shows a simulation of the electric field inside an exemplary modular electronic system.

Fig. 9 schematically shows a simulation of the electric field inside a modular electronic system according to embodiments.

### DETAILED DESCRIPTION OF THE INVENTION

Reference will now be made in detail to various embodiments, one or more examples of which are illustrated in each figure. Each example is provided by way of explanation and is not meant as a limitation. For example, features illustrated or described as part of one embodiment can be used on or in conjunction with other embodiments to yield yet further embodiments. It is intended that the present disclosure includes such modifications and variations.

Within the following description of the drawings, the same reference numbers refer to the same components. Generally, only the differences with respect to the individual embodiments are described. When several identical items or parts appear in a figure, not all of the parts have reference numerals in order to simplify the appearance.

The systems and methods described herein are not limited to the specific embodiments described, but rather, components of the systems and/or steps of the methods may be utilized independently and separately from other components and/or steps described herein. Rather, the exemplary embodiment can be implemented and used in connection with many other applications.

Although specific features of various embodiments of the invention may be shown in some drawings and not in others, this is for convenience only. In accordance with the principles of the invention, any feature of a drawing may be referenced and/or claimed in combination with any feature of any other drawing.

Generally, embodiments of the invention pertain to modular electronic systems having a plurality of electronic modules. The modules include enclosures respectively housings and medium to high voltage electronic circuits, i.e. power switches, together forming an electronic module, for example a PEBB. The enclosures include a dielectric material, which has a conductive layer on either an inside or an outside face. Several enclosures may be arranged in an array, for example an m x n matrix (i.e. an m by n matrix). Thereby, the enclosures may be arranged such that they can be fitted respectively mounted to each other via mounting elements on the outer faces of the enclosures. In embodiments, the enclosures may be pullably mounted in a rack or cabinet, so that the electrical contacts (operating voltage, ground, etc.) are typically provided on the rear side of the modules. The terms cabinet and rack are used interchangeably herein, wherein they are not necessarily closed bodies; they may also be shelf-shaped elements for inserting electronic modules. The term "medium voltage" mentioned above is understood as a rated voltage of about 1000 Volts up to about 36000 Volts (DC, or rms voltage in case of AC). A voltage higher than this is regarded hereinafter as "high voltage". One has to be aware that the equipment must be able to withstand impulse voltages (e.g. a lightning impulse) that are typically much higher (e.g. above 100 kV) even for MV equipment. See e.g. IEC 61800-5-1, Tab. 8 for reference.

The dielectric material of the enclosure fulfils the standards for solid insulation towards neighboring enclosures respectively modules. The thickness of the dielectric is dimensioned according to the breakdown strength of the material, the applied voltages and the individual configuration of the system. Thereby, the face of at least one enclosure coated with a conductive layer is, in an operational state of the respective electronic module, connected to a defined potential, so that the conductive layer is effectively a field shaping conductive layer.

Typically, the enclosure is formed such that the conductive layer, located on the inside or outside of the enclosure, has a smooth surface and is substantially free of sharp edges, so as to avoid local peak values, which might promote partial discharge. The conductive layer covers either the entire outer or inner surface of the enclosure wall, or in other cases covers several areas of the enclosure wall located about edge portions of the enclosure, whereby areas on the faces of the enclosure are not covered by the conductive layer. Hence, in the case that the enclosure has a box shape, the conductive layer may only cover areas about the edge portions, such that the conductive layer has an overall shape of a box frame, whereas the dielectric enclosure can substantially be a closed box with ventilation openings on front and rear. Also, the dielectric enclosure may have the same box frame shape as the conductive layer described above, such that some or all side faces of the box respectively cuboid are left out. Also, one or more of the side surfaces (meaning all six faces of a cuboid) may be individually coated with a conductive layer, such that the conductive layer covers at least one surface area forming an intermediate portion in between edge portions of the dielectric enclosure wall.

By connecting the conductive layer, for example on the inside of the enclosure wall, to a potential identical to the potential of the electronic circuit inside the module, a homogenization of the electric field in the air gap between adjacent, respectively neighboring modules, can be achieved.

Further, due to the homogenized electric field in the air gap, a narrower air gap may be construed, than would be possible with a conventional dielectric enclosure.

Further, a conductive layer on the inside of the enclosure wall may be isolated/insulated from the electronic circuit and have a floating potential, or the conductive layer may be connected to ground.

In embodiments, the conductive layer (herein also called field shaping conductive layer) covers at least 30 to 40 % of the overall inner face of the enclosure wall, or at least 30 to 40 % of the overall outer face of the enclosure wall. The field shaping conductive layer may be applied in form of a coating that is applied to the enclosure wall after forming the same.

In embodiments, the enclosure wall can typically be a single-bodied enclosure wall. The enclosure wall typically includes at least one of a polymer plastic, a fiber reinforced polymer (FRP), a polymer resin, or a ceramic. With the exception of ceramic as the exclusive material of the enclosure, it may be formed integrally by a process such as injection molding, casting, or pultrusion. Also, the enclosure wall may be formed from several pieces, for example from two halfs together forming a box shape. Depending on the requirements and the use of the enclosure, the enclosure wall 30 may comprise a fiber reinforcement that may comprise wood or cellulose based materials. If the electrically conductive layer is a polymer, too, it might be molded on the enclosure wall at the time of manufacturing the latter or shortly thereafter.

The enclosure may have a variety of shapes, typically it has the shape of a cuboid, respectively a box. It may, however, also have a hexagonal shape or be a combination of more than one cuboid of different sizes or shapes. Typically, the enclosure or box has openings on its front and back, respectively on two opposite surfaces, which serve as clearings for cooling air for the electronic circuitry in the interior. Hence, the enclosure forms a kind of channel or tube from front to back for air cooling. This tubular shape does not necessarily exhibit a circular cross section, but can have a variety of cross sectional shapes, such as squares, triangles, hexagons, or the like. At the front and the back, where the enclosure has the openings, respectively around the openings, the conductive layers on the inner wall or outer wall of the enclosure are terminated, such as to fulfill the insulation standards for air clearance and creepage. In embodiments, depending on the individual setup, also ripples can be provided/structured in the dielectric material of the enclosure, in order to extend the creepage surface distance.

In embodiments, which can be combined with other embodiments described herein, the openings in the front and back may be provided with a grill respectively grid structure to protect from touching according to high voltage insulation standards. This structure is typically connected to the field shaping conductive layer. Where suitable, the grill can can be electrically connected to ground potential

In embodiments, the enclosure may be a frame. This means, that there are openings not only - as described before - in the front and back surfaces (wherein front and back may be defined with respect to the resulting air channel, or also with respect to the direction in which the enclosure/module may be inserted into a rack or an array of other enclosures/modules), but also other faces of the cuboid have openings, such that in an embodiment, the enclosure is a box-shaped frame having openings instead of all the side surfaces.

Thereby, embodiments pertain to an electronic system including a plurality of the described electronic modules. The modules are typically arranged in an array. Either, the enclosures of the modules exhibit elements in their outer surfaces which serve as mounting means to connect the various modules to each other, for example rails and/or grooves. Thereby, in embodiments, the rail elements may also be a part which is integral to the enclosure, respectively a part of the enclosure such as edges are used as a rail element.

Thus, in embodiments, an electronic module includes an enclosure which has on its outside at least one of a rail element, or a groove forming a guiding structure for assisting the insertion of the enclosure into a cabinet or rack to form the modular electronic system, and the extraction of the enclosure out of the modular electronic system. The electronic modules are typically mounted in a frame, cabinet or rack having openings, rails, grooves or other standard means for mounting purposes. The electronic modules can be plugged in or out from the array and may also include hot-plug-facilities, for example in that the electrical contacts are provided on the back of the modules, so that they enter the slot first during plugging in.

In embodiments, the modules themselves also have a modular structure. Thus, the electronic circuit board is mounted inside the enclosure with detachable means, such as rails. For access to the inside of the electronic module, hence the circuit, one - typically front or back - surface of the enclosure is typically configured that it can be opened for removing the circuit board. Thus, the electronic system including the modules having enclosures, arranged in an array, has a two-stage or double modular structure. On the one hand, the electronic modules including the enclosure and the circuit therein may be detached from the system. By doing so, the system may for example be scaled to various power requirements or cost requirements quickly and with great flexibility. At the same time or additionally, the circuit boards may be removed or inserted individually into the single enclosures of modules.

Embodiments according to the invention allow a compact system design due to the field shaping conductive layer on the enclosure, which is connected to a potential, which may be the working potential of the electronic circuit inside the module. Hot swapping of modules and/or electronic circuits in the modules is obtainable. Due to the effective isolation principle, small form factors for the modules are possible, respectively little air space is required between the electronic circuits and the housing, or between the enclosures of neighboring modules. Therefore, compact and at the same time lightweight small modules and entire systems may be obtained.

In embodiments, the enclosure walls of two neighbouring electronic modules are separated by an air gap. Thereby, the air gap is dimensioned such that Vₚₑₐₖ in between the at least two neighboring electronic modules is achievable. Thus, the field strength between the electronic circuit inside the module and the conductive layer (on potential) is, depending on the actual potential of the conductive layer, close to zero or can be greatly minimized with respect to the case in which the conductive layer of the enclosure is grounded, for example. Hence, a problem of partial discharge inside the electronic module is greatly reduced. As the electronic modules have a relatively smooth or perfectly smooth outer surface free of edges or small radiuses, the electric field caused by the conductive-layer-coated enclosure is relatively homogeneous. The conductive layer on potential is thus a field shaping conductive layer. Even when adjacent modules are on different potential, the field between their neighboring parallel surfaces is nearly homogeneous and hence uncritical in terms of partial discharge. Air insulation is thus obtainable, reducing the risk of partial discharge, which is otherwise often critical in medium voltage applications in air insulated enclosures.

In some cases, the conductive layers of neighboring modules may also be on the same potential, such that there is no potential difference. In this case, an electrical conductor may connect the elements so as to further promote or assure that they are on the same potential. Hence, said electrical conductor electrically connects a portion of the field shaping conductive layer of a first of the two neighboring modules with the field shaping conductive layer of a second of the two neighboring modules.

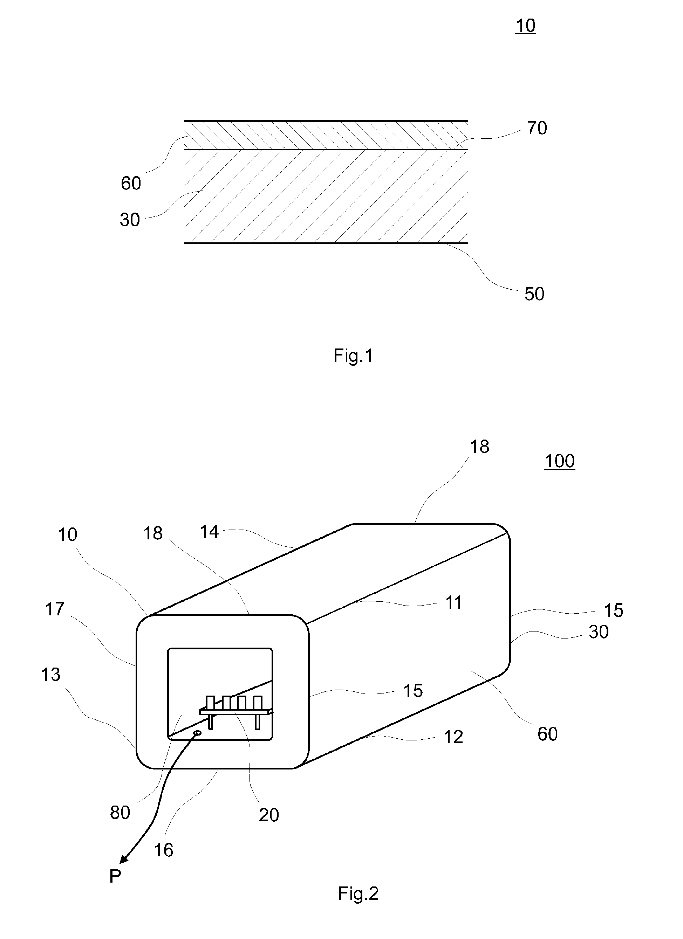

Fig. 1 shows a cross-sectional view of an enclosure 10 according to embodiments. It includes a dielectric material 30 which is abutted on one face 50, 70 with a conductive layer 60. The layers typically comprise a metal or metal alloy, but may also include non-metallic conductive materials such as carbon in its modifications. The metals may, for example be copper, aluminium, silver, gold, an iron alloy, or alloys of any of the former. The enclosure wall 30 may include at least one of a polymer and a fiber reinforced plastic, for example polyurethane. In embodiments, the enclosure may be produced integrally from one piece, for example by one of injection molding, casting, or pulltrusion. In embodiments, the conductive layer 60 may be applied on the inside or outside of the enclosure wall 30, hence the surface 50 of the dielectric enclosure wall may face towards the inner space of the enclosure with the electronic circuit (not shown in Fig. 1, refer to Fig. 2), or may face towards an outside of the enclosure.

Fig. 2 shows an electronic module 100 according to embodiments. It has-not limiting - two ventilation openings (only the front opening 80 visible), an electronic circuit 20, and an enclosure 10 having the properties as described with respect to Fig. 1 above. The thickness of the dielectric material 30 is dimensioned according to the breakdown strength of the material and the applied field strengths. Thereby, the conductive layer 60, here on the outside of enclosure 10, is in an operational state of the electronic module 100 connected to a defined potential P. As is shown, the connection of the conductive layer 60 to the potential P may be on a front side or on a rear side with respect to the insertion direction into the cabinet. If required the connection means for establishing the electrical connection to potential P can be formed as a plug on the rear side of the the electronic module 100 such that the connection can be plugged when the module is pushed into a rack or cabinet 160.

In embodiments where the conductive layer 60 is provided on the inside of enclosure 10 (different to Fig. 2), the layer 60 may be connected directly to the electronic circuit 20 inside the enclosure by a conductor.

Typically, the enclosure wall 30 is formed such that the conductive layers on the inside or outside have a smooth surface and are substantially free of sharp edges, small radiuses etc., so that the electric field in the exterior of the module 100, caused by the potential P of the field shaping conductive layer during operation, is substantially free of local peak values, which might promote partial discharge. The field shaping conductive layer 60 may, e.g., be applied in form of a coating or film that is applied to the enclosure 10 after forming the enclosure wall 30, for example as a spray. It may also be applied as a shrink film or a shrink hose. Various techniques for applying a metal coating or layer to a dielectric surface are well known to a skilled person and shall not be described in greater detail.

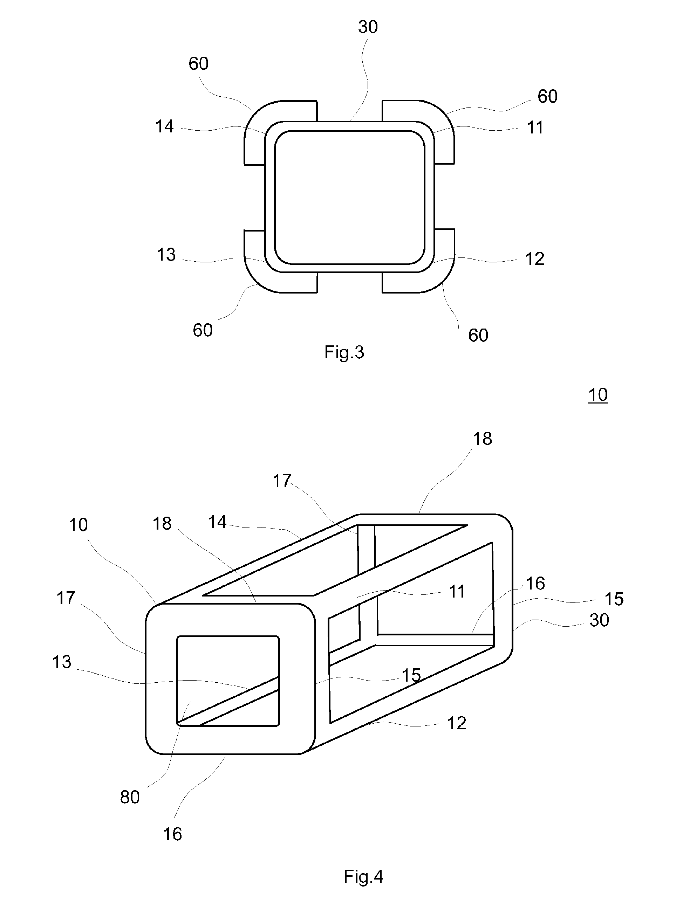

In embodiments, there are several possibilities for the application of the field shaping conductive layer, of which one is shown in Fig. 2, hence the layer basically covers the whole - inner or outer - surface of the enclosure wall 30 and thus the enclosure 10. In other cases, only a part respectively fraction of the surface may be covered by the field shaping conductive layer 60. Fig. 3 shows a cross sectional view through a middle portion (with reference to an axis from front to back) of an enclosure geometrically similar to that of Fig. 2. Differently from that enclosure, the conductive layer 60 in Fig. 3 only covers edge portions 11, 12, 13, 14 (refer also to Fig. 2) from a front of the enclosure along its length to the back. The layer 60 is shown having a large thickness, which is not to scale with the thickness of wall 30, and for illustrational purposes only.

Fig. 4 shows a perspective front view of a frame-like insulation body for an enclosure according to a futher embodiment. In this case the field shaping conductive layer 60 is film-shaped and can be applied to the enclosure 10 after forming the enclosure wall 30, for example. If required, the electrically conductive layer is a shrink film or even a shrink hose having a comparatively thin wall thickness such that the layer can be bent about edges of the frame-like insulation body 30 with ease such that no air pockets or air bubbles arise.

The edge portions 11, 12, 13, 14, 15, 16, 17, 18 of the frame-like insulation body 30 that can be seen in Fig. 4 confer the dielectric enclosure a substantially box shaped form, wherein the windows in the frame may contribute to an enhanced cooling compared to known insulation devices. Depending on the embodiment of the enclosure 10, the conductive layer 60 is applied on the inside or outside of the enclosure wall 30 of the frame structure.

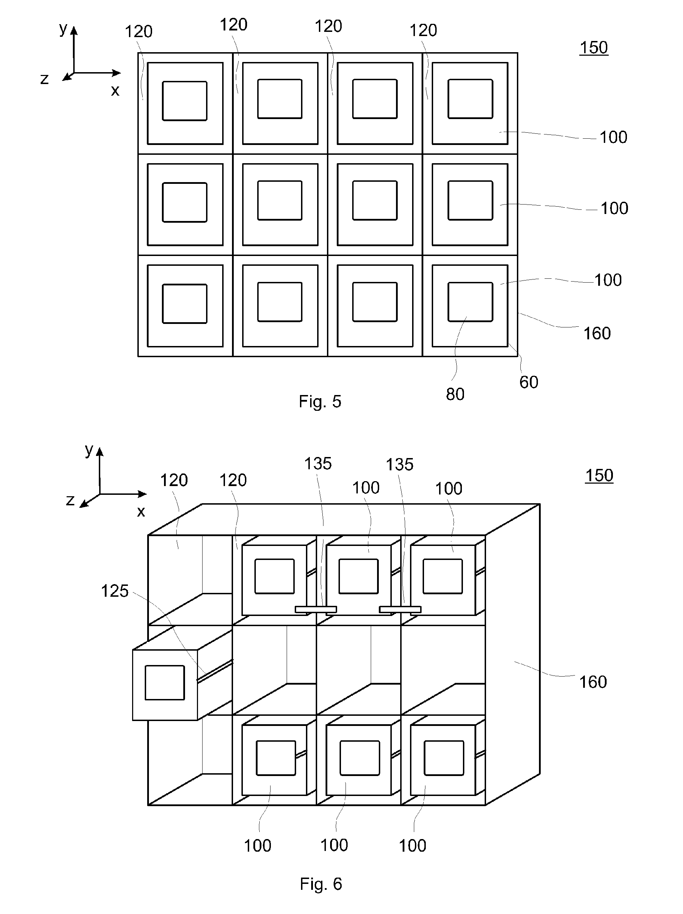

Fig. 5 schematically shows an electronic system 150 according to an embodiment. A plurality of electronic modules 100 with enclosures 10 as described before are arranged in an array defining an x and y plane (drawing plane). The modules 100 may be plugged in and out of the system 150 by moving them in the z-direction (extending perpendicular to the drawing plane).

Fig. 6 shows another view of the system of Fig. 3. The modules 100 may typically, but not necessarily be arranged in an m by n matrix (here, non-limiting, 4 x 3) as shown. Thereby, the enclosures 10 of the modules 100 typically exhibit elements on or in their outer surfaces, which serve as mounting means to connect the various modules, for example rail elements 125 and/or grooves (not shown). The electronic (e.g., PEBB) modules 100 can be plugged in or out from the system 150 - in any of the individual setups as described above - and may also include hot-plug-facilities, for example in that the electrical contacts are provided on the back of the modules, so that they enter the slot 120 first during plugging in. In Fig. 6, one module is shown half-way during mounting or removal of the same. In embodiments, neighboring modules may be connected by a conductor 135 in order to ensure that they are on the same potential.

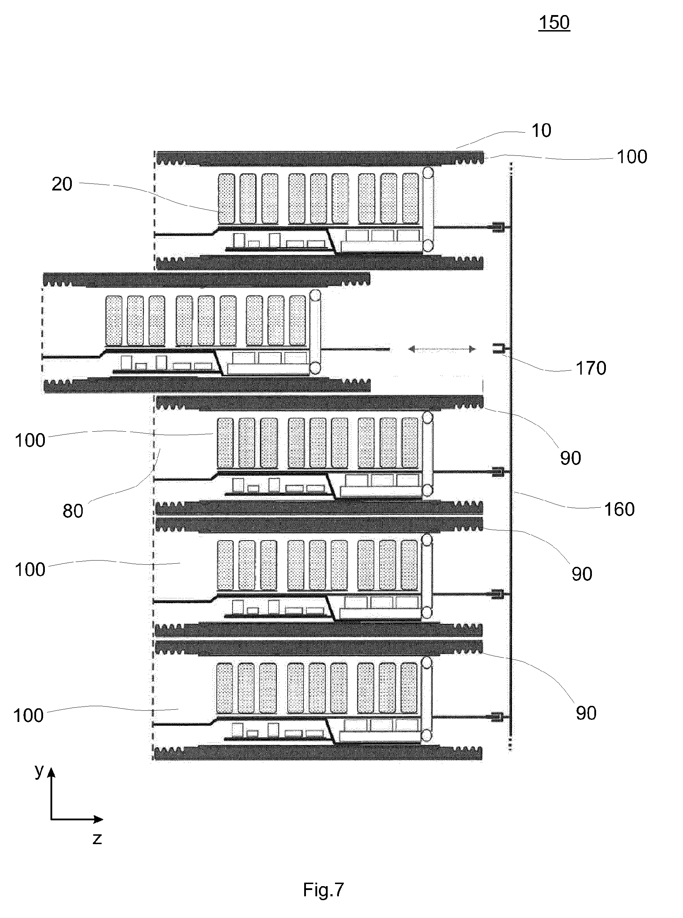

Fig. 7 shows a cross sectional side view of a system according to embodiments, similar to those shown in Fig. 6 and Fig. 7. Thereby, the earlier described exchangeability of an electronic circuit 20 within a module 100 is shown. That is, the circuit is pulled from the front of the system (left in drawing) out of module 100 via the front ventilation opening 80, while the connection to the rack 160 is unplugged (see arrow). Also, a design with ripples 90 at the end of the enclosure 10 towards opening 80 is shown in order to increase withstand against creepage.

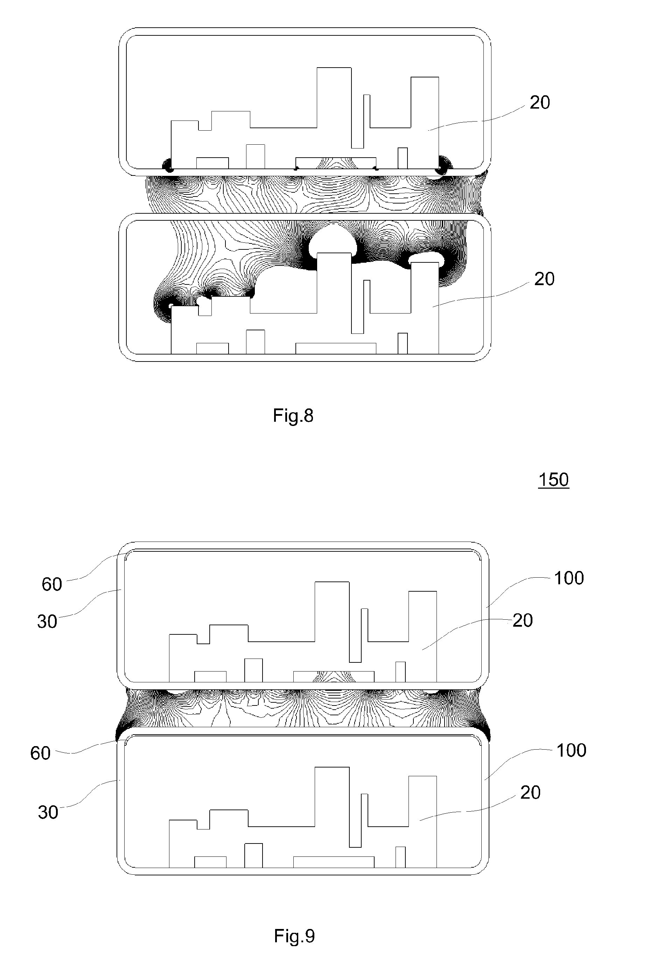

Fig. 8 schematically shows a plot of a computational simulation of the electric field inside an exemplary modular electronic system according to conventional technology, having dielectric housings around the electronic circuits 20. Two modules are shown, wherein the electronic circuits 20 inside the housings on the same test potential. It can be seen that the field lines of the electric field exhibit a highly irregular spatial distribution, also in the space between the housings, indicating field peaks and leading to a significant risk of partial discharges.

Fig. 9 schematically shows a plot of a simulation of the electric field inside a modular electronic system 150 according to embodiments. Thereby, the two electronic modules 100 have each a first conductive layer 60 located on the inside of enclosure wall 30, whereby the layers only cover the top part of the enclosures. The layers 60 are each connected to the electric potential of their respective electronic circuit 20 inside the enclosures. As can be seen, the field lines of the electric field in the air gap between the two modules 100 are much more homogeneous than in the case shown in Fig. 8, without conductive layer on the enclosure.

When the electric circuits 20 in neighboring modules 100 are on different operating potentials, also the respective conductive layers may be connected to these different potentials.

This written description uses examples to disclose the invention, including the best mode, and also to enable any person skilled in the art to practice the invention, including making and using any devices or systems and performing any incorporated methods. While various specific embodiments have been disclosed in the foregoing, those skilled in the art will recognize that the spirit and scope of the claims allows for equally effective modifications. Especially, mutually non-exclusive features of the embodiments described above may be combined with each other. The patentable scope of the invention is defined by the claims, and may include other examples that occur to those skilled in the art. Such other examples are intended to be within the scope of the claims if they have structural elements that do not differ from the literal language of the claims, or if they include equivalent structural elements with insubstantial differences from the literal language of the claims.

## Claims

1. Modular electronic system (150) for medium or high voltages, comprising:
- a cabinet (160) having a number of slots (120) arranged in an array,
- at least one electronic module (100) provided in a slot (120) of the cabinet, the module comprising:
- an enclosure (10) with a three dimensional shape, having an enclosure wall (30) comprising a dielectric material, and a field shaping conductive layer (60) abutting a face (70) of the enclosure wall (30),
- an electronic device (20) located in the enclosure (10),
wherein the field shaping conductive layer (60) is electrically connectable to a predefined electric potential (P) that is present in an operating state of the modular electronic system (150).

2. The system of claim 1, wherein the field shaping conductive layer (60) on the enclosure wall (30) of the at least one electronic module (100) fulfils at least one of the following conditions:
- it covers several areas of the enclosure wall (30) located about edge portions (11, 12, 13, 14, 15, 16, 17, 18) of the enclosure (10);
- it covers at least one further surface area forming an intermediate portion in between edge portions (11, 12, 13, 14, 15, 16, 17, 18) of the enclosure (10).

3. The system of claim 2, wherein the field shaping conductive layer (60) covers at least 30 % of the overall inner face of the enclosure wall or at least 30 % of the overall outer face of the enclosure wall.

4. The system of any preceding claim, wherein the field shaping conductive layer (60) is a coating that is applied to the enclosure (10) after forming the enclosure wall (30).

5. The system of any preceding claim, wherein the enclosure wall (30) is a single-bodied enclosure wall, formed integrally by a process from the list consisting of: injection molding, casting, and pulltrusion.

6. The system of any one of claims 1 to 4, wherein the enclosure wall (30) comprises at least one of: a polymer plastic, a fiber reinforcement, a polymer resin, a ceramic.

7. The system of any preceding claim, wherein the enclosure (10) comprises at least two ventilation openings (60, 80) that are preferably arranged on opposite surfaces facing in a direction perpendicular to the array, preferably an m x n plane, of the cabinet (160).

8. The system of any preceding claim, wherein the overall shape of the enclosure (10) is tubular.

9. The system of any preceding claim, wherein the field shaping conductive layer (60) comprises metal.

10. The system of any preceding claim, wherein the field shaping conductive layer (60) comprises a non-metallic electrically conductive material.

11. The system of claim 10, wherein the field shaping conductive layer (60) is a film.

12. The system of any preceding claim, wherein the enclosure wall (30) of at least one electronic module (100) comprises a section with ripples (90).

13. The system of any preceding claim, wherein the enclosure walls (30) of two neighbouring electronic modules are separated by an air gap, and wherein the electric field in the gap can be homogenized by the conductive layers (60) of the neighboring modules.

14. The system of any preceding claim, wherein an electrical conductor means (135) is provided in between two neighboring modules (100) such that said electrical conductor means electrically connects a portion of the field shaping conductive layer (60) of a first of these two neighboring modules with a second portion of the field shaping conductive layer (60) of a second of these two neighboring modules.

15. The system of any preceding claim, comprising at least two electronic modules (130)
wherein one of these two electronic module (130) is displaceable against the other electronic module (130) in an operating state of the modular system in a direction extending transversely, in particular perpendicularly, to the x-y-plane.

16. The system of claim 1, wherein the field shaping conductive layer (60) is electrically connectable to an element of the electronic device (20).

17. The system of any preceding claim, wherein the enclosure (10) comprises, on its outer face, at least one of the following: a rail element (125), and a groove forming a guiding structure for assisting the insertion of the enclosure (10) into the modular electronic system (150) and the extraction of the enclosure (10) out of the modular electronic system (150) in a drawer-like manner.

18. The system of any preceding claim, wherein during insertion of a module (100) into the cabinet (160), the conductive layer (60) is automatically connectable via contact element (135) to the conductive layer of a neighboring module (100).
